# EUROPÄISCHE PATENTSCHRIFT

(11) **EP 3 615 843 B1**
(45) Veröffentlichungstag und Bekanntmachung des Hinweises auf die Patenterteilung: **25.08.2021**
(21) Anmeldenummer: 18720223.9
(22) Anmeldetag: 24.04.2018
(51) Int. Cl.: F16G 13/16

(54) **SYSTEM ZUR LAGE- UND/ODER LEITUNGSÜBERWACHUNG IN EINER ENERGIEFÜHRUNGSKETTE**
SYSTEM FOR POSITION MONITORING AND/OR LINE MONITORING IN AN ENERGY CHAIN
SYSTÈME POUR LA SURVEILLANCE DE POSITION OU DE LIGNE DANS UNE CHAÎNE DE TRANSPORT D'ÉNERGIE

(30) Priorität: 24.04.2017 DE 202017102410 U
(43) Veröffentlichungstag der Anmeldung: 04.03.2020
(73) Patentinhaber: Igus GmbH, 51147 Köln (DE)
(72) Erfinder: HABERING, Richard, 51143 Köln (DE); BARTEN, Dominik, 53340 Meckenheim (DE); SCHMER, Konstantin, 50827 Köln (DE)
(74) Vertreter: Lippert Stachow Patentanwälte Rechtsanwälte
(86) Internationale Anmeldenummer: PCT/EP2018/060485
(87) Internationale Veröffentlichungsnummer: WO 2018/197499

(56) Entgegenhaltungen:
- EP-A2- 1 521 015
- DE-U1- 20 312 266
- US-A1- 2015 122 047

## Beschreibung

Die Erfindung betrifft allgemein ein System zur Lage- und/oder Leitungsüberwachung in einer Energieführungskette. Die Erfindung betrifft speziell ein Überwachungssystem für eine Energieführungskette, die zum dynamischen Führen mindestens einer Leitung, wie z.B. eines Kabels, Schlauchs oder dergleichen, zwischen einer Basis aund einemdazu relativbeweglichen Mitnehmer dient. Ein gattungsgemäßes System umfasst dabei einerseits eine Energieführungskette die entlang eines Verfahrwegs verfahrbar ist und dabei variabel, je nach Mitnehmerposition, ein bewegliches Trum mit einem Anschlussende für den Mitnehmer, ein ruhendes Trum mit einem Anschlussende für die Basis und zwischen beiden Trumen einen Umlenkbogen bildet. Andererseits umfasst das System eine Überwachungsvorrichtung mit mindestens einem an der Energieführungskette angeordneten Geber, wobei die Überwachungsvorrichtung ein anhand des Gebers erzeugtes Signal auswertet um zu überwachen, ob im Betrieb der Energieführungskette ein Fehlerzustand auftritt.

Unterschiedliche Systeme dieser Art sind bereits bekannt. So offenbaren z.B. die Patentanmeldungen WO 2004/090375 A1 und WO 2013/156607 A1 Systeme mit einem Kraftaufnehmer zwischen dem Mitnehmer und der Energieführungskette, um zu überwachen, ob die auftretenden Kräfte innerhalb eines Toleranzbereichs liegen.

Die Patentanmeldung WO 2015/118143 A1 offenbart ein System mit einem mechanisch wirkenden Geber, der anhand einer Auslöseschnur eine Beschädigung der Energieführungskette erfasst. Ein ähnliches System ist aus der JP 2009 052 714 A bekannt, wobei hier ein Brucherkennungssystem mit einer optischen Faser vorgeschlagen wird, d.h. anhand der Lichtmenge kann ein Bruch erkannt werden.

Die vorgenannten Systeme haben den Nachteil, dass sie grundsätzlich nur eine bereits eingetretene Beschädigung erkennen. Sie erlauben damit insbesondere keine prospektive Instandhaltung bzw. vorausschauende Wartung (Engl. predictive maintenance).

Ein Überwachungssystem das zustandsorientierte Instandhaltung erlauben kann wurde in der Patentanmeldung EP 1 521 015 A2 beschrieben. Hierbei wird z.B. anhand elektromechanisch wirkender Verschleißelemente der Abnutzungsgrad der Energieführungskette lokal begrenzt ermittelt, z.B. abnutzungsbedingter Verschleiß an der Schmalseite einer Kettenglieds. Dieses System liefert jedoch keine Information über die aktuelle Lage der Energieführungskette oder über den Zustand einer geführten Leitung.

Im Gebrauchsmuster DE 20 2004 005 858 U1 hat die Anmelderin ein Überwachungssystem vorgeschlagen, das Information über die aktuelle Lage der Energieführungskette liefert, das auch Fehlerzustände erkennen kann. Hierzu wurde vorgeschlagen, and den Kettenglieder Sensoren anzuordnen, die von der Schwenklage des Kettengliedes abhängige Signale erzeugen. Als Sensoren wurden z.B. sog. Quecksilber-Neigungsschalter vorgeschlagen, die auf Lageänderungen reagieren und als Neigungssensor die Raumlage des jeweils zugeordneten Kettenglieds anzeigen. Diese Lösung ist technisch aufwendig, insbesondere hinsichtlich der Montage bzw. Herstellung, da eine Viehzahl Sensoren montiert und verdrahtet werden müssen.

Im Patent EP 2 235 396 B1 hingegen wird beiläufig vorgeschlagen, externe elektrische Kontaktmittel entlang des Verfahrwegs, z.B. im Führungskanal der Energieführungskette, anzuordnen, mit welchen die Energieführungskette bei störungsbedingtem Ausschlagen in Kontakt geraten soll.

Die EP1521015A2 offenbart eine aus Kunststoff einstückig extrudierte Energieführungskette. Die Kettenglieder dieser Energieführungskette sind durch Trennschlitze voneinander getrennt und durch Verbindungsstege miteinander verbunden. Sie umschließen einen Kabelkanal zur Führung von Kabeln. In die Kette sind elektrische Leitungen in Form von Drähten eingebettet, die beim Verfahren der Kette ebenso wie diese selbst ständig wechselverformt werden. Die Leitungen sind so konzipiert, dass sie nach einer vorbestimmten Anzahl von Wechselverformungen, die eine für den Verschleiß der Kette kritische Zahl darstellt, brechen. Dadurch wird ein Stromkreis unterbrochen, an den eine Antriebseinrichtung der Kette angeschlossen ist. Wenn eine der Leitungen bricht, wird die Antriebseinrichtung für die Kette automatisch abgeschaltet. Zudem sendet eine angeschlossene Signaleinrichtung ein Signal aus.

Es ist auch bereits bekannt, die zu erwartende Lebensdauer von Kabeln in Energieführungsketten anhand von Laborversuchen zu bestimmen aufgrund eines charakteristischen Anstiegs des Leiterwiderstands, der typisch erst nach vielen Hunderttausenden bzw. Millionen Testzyklen eintritt.

Schließlich ist aus dem Patent US 7,023,217 B1 in diesem Zusammenhang bereits ein Überwachungssystem bekannt, das es erlaubt, eine Erfassung des Verschleißzustands elektrischer Leiter, insbesondere von Flachbandkabeln, z.B. in einem Kabelschlepp zu realisieren. Hierbei werden mehrere Leiter des Flachbandkabels anhand einer aufwendigen Schaltungsanordnung mit einem Relais-Multiplexer und einem Präzisions-Voltmeter durchgemessen. Durch die aufwendige Schaltungsanordnung und die vorgeschlagene Anschlusstechnik an beiden Anschlussenden der Energieführungskette ist diese Lösung für einen Einsatz im praktischen bzw. aktiven Betrieb einer Energieführungskette jedoch wenig tauglich.

Es soll gemäss einer Aufgabe der vorliegenden Erfindung ein einfach zu montierendes System vorgeschlagen werden, das eine Aussage über die aktuelle räumliche Lage der Energieführungskette liefert. Das System soll dabei insbesondere vor Beschädigung durch unerwünschtes Aufsteigen oder Aufbäumen schützen. Diese Aufgabe wird durch ein System nach Anspruch 1 gelöst.

Bei einem gattungsgemässen Überwachungssystem nach dem Oberbegriff aus Anspruch 1 kann vorgesehen sein, dass der Geber einen von der Energieführungskette geführten elektrischen Indikatorleiter aufweist, der zumindest entlang einer überwiegenden Länge des beweglichen Trums verläuft. Dabei kann weiter vorgesehen sein, dass die Überwachungsvorrichtung eine Schaltung umfasst, die mit dem Indikatorleiter verbunden ist, um anhand des Indikatorleiters mindestens eine elektrische Größe zu erfassen, und die Überwachungsvorrichtung kann eine vorzugsweise programmierbare Auswertungseinheit umfassen, die das von der erfassten Größe abhängige Signal, z.B. unmittelbar oder ggf. nach Signalverarbeitung, mit mindestens einem vorgespeicherten Referenzwert oder einem Toleranzbereich vergleicht.

Der Begriff Geber wird hierbei mit ganz allgemeiner Bedeutung, insbesondere als gleichbedeutend mit Sensorkomponente, verwendet (d.h. meint z.B. nicht Encoder oder dgl.).

Die Auswertungseinheit kann dabei die anwendungsspezifische modulare Anpassung der Überwachungsvorrichtung erlauben, auch bei gleichbleibender Topologie der Erfassungsschaltung, z.B. durch geeignetes Programmieren der Auswertungsfunktionen und/oder variable Speicherung der Betriebsparameter in der Auswertungseinheit. Die Auswertungseinheit kann dabei u.a. auch ein modular aufgebautes System mit mehreren Schaltungsmodulen ermöglichen, welche insbesondere je nach dem gewünschten Überwachungsaspekt jeweils baugleich und unabhängig vom verwendeten Indikatorleiter ausgeführt sind, z.B. einen Schaltungstyp für die Lageüberwachung und einen Schaltungstyp für die Leitungsüberwachung. Zudem kann die flexible Berücksichtigung diverser Variablen, wie anwendungs- und laufzeitabhängiger Parameter sowie von Umgebungsparametern, z.B. Länge der Energieführungskette, Krümmungsradius, Zyklenanzahl, Temperatur usw. erleichtert werden. Die Erfassungsschaltung und die Auswertungseinheit können als Module in eine gemeinsame Baugruppe, ggf. auch auf einer Leiterplatte, integriert sein oder räumlich getrennt ausgeführt sein.

Insbesondere zur Realisierung einer echten Messung bzw. messtechnischen Erfassung der elektrischen Größe kann es vorgesehen sein, dass die Schaltung eine eingangsseitig mit dem Indikatorleiter verbundene Messeinrichtung umfasst, um die elektrische Größe, insbesondere einen elektrischen Parameter des Indikatorleiters, durch quantitative Messung zu erfassen und ausgangsseitig ein davon abhängiges Signal für die Auswertungseinheit bereitzustellen. Der Begriff Messung kann dabei im Sinne der Definition in der DIN-Norm DIN 1319 verstanden werden.

Insbesondere aber nicht nur im Fall einer messtechnischen Erfassung kann die Auswertungseinheit eine integrierte Logikschaltung aufweisen, wie z.B. einen Mikrocontroller oder dgl., mit einem Referenzwertspeicher zur Auswertung der erfassten bzw. gemessenen Größen in Bezug auf einen oder mehrere Referenzwerte, z.B. einen Toleranzbereich. Dabei kann die Messeinrichtung beliebig ausgeführt sein, wahlweise voll analog, teilanalog und teildigital oder rein digital ausgeführt. Aufgrund der vorzugsweise programmierbaren Logikschaltung kann die Auswertungseinheit modular und wahlweise an die Messschaltung anpasst werden. Der Referenzwertspeicher kann auch getrennt von der eigentlichen Auswertungseinheit ausgeführt sein, z.B. wenn letztere den ersteren bedarfsweise abfragt, ist aber vorzugsweise Teil der Logikschaltung.

Die modulare Bauweise erlaubt z.B. - unabhängig vom eingesetzten Indikatorleiter - eine anwendungsangepasste Widerstands- oder Impedanz-Messung. Da der Absolutwert u.a. von der Gesamtlänge des Indikatorleiters abhängt, welche zumindest entlang einer überwiegenden Länge des beweglichen Trums verlaufen soll, d.h. sind die zu erwartenden Messwerte stark von der Anwendung abhängig, in der die Energieführungskette eingesetzt wird. Durch laufende Widerstands- oder Impedanzmessung kann z.B. ein bevorstehender Ausfall von Adern durch Ermüdungsbruch in einem elektrischen Kabeln relativ zuverlässig vorhergesagt werden. Anders als z.B. in US 7,023,217 B1 vorgeschlagen, ist es aber mit der vorgeschlagenen Auswertungseinheit nicht nötig, eine redundante inaktive Energieführungskette bzw. Leitung allein zu Referenzzwecken vorzusehen.

Der mindestens eine Indikatorleiter erstreckt sich vorzugsweise zumindest über einen überwiegenden Längenanteil der Energieführungskette, insbesondere über den gesamten im Betrieb verfahrbaren Längenanteil der Energieführungskette. Vorzugsweise erstreckt sich der Indikatorleiter dabei zumindest über die dem Mitnehmer nahe befindliche bzw. an diesen anschließende Hälfte der Länge der Energieführungskette, da hier durch Zug- und Schubkraft bedingte Beanspruchung der Verschleiß meist am größten ist und atypisches Verhalten dort am häufigsten auftritt. Der Indikatorleiter soll sich dabei zumindest über den kritischen Längsabschnitt der Energieführungskette erstrecken, typisch das erste Drittel vom Mitnehmer aus betrachtet.

Der elektrische Indikatorleiter kann separat, als zusätzliche Leitung, oder beispielsweise als Bestandteil eines in der Anwendung genutzten Kabels ausgeführt sein. Der Indikatorleiter kann in beiden Fällen beispielsweise auf die gleiche Weise wie eine aktive Leitung und in der Energieführungskette geführt sein, insbesondere durchgehend von einem Ende der Energieführungskette zum anderen und ggf. auch in Form einer Schleifenform wieder zurück zum einen Ende.

Gemäß der Erfindung ist ein Überwachungssystem zur Lageüberwachung einer Energieführungskette nach Anspruch 1 vorgesehen, z.B. für eine Aufstiegsüberwachung bei der Hin- und Her-Bewegung der Energieführungskette.

Erfindungsgemäß hat das System nach dem Oberbegriff aus Anspruch 1 zur Lösung der vorgenannten Aufgabe als Geber mindestens einen oder mehrere von der Energieführungskette geführten elektrischen Indikatorleiter, der zumindest entlang einer überwiegenden Länge des beweglichen Trums verläuft. Hierbei hat die Überwachungsvorrichtung ebenfalls eine mit dem Indikatorleiter verbundene Schaltung, welche anhand des Indikatorleiters eine elektrische Größe erfasst. Zudem weist die Schaltung einen Generator auf, welcher ein zeitvariables Anregungssignal, insbesondere ein Wechselstrom- oder Impulssignal, erzeugt, das in den Indikatorleiter oder einen diesen elektromagnetisch, z.B. induktiv beeinflussenden zusätzlichen Leiter eingespeist wird.

Dadurch kann die Schaltung am Indikatorleiter einen bezüglich der räumlichen Lage des Indikatorleiters geometriesensitiven elektrischen Parameter als Größe erfassen. Im Sinne der Elektrodynamik bewirkt das durch den Generator induzierte, zeitlich veränderliche elektromagnetische Feld bei geeigneter Anordnung eine Wechselwirkung mit Indikatorleiter, die eine Funktion der räumlichen Lage des Indikatorleiters, d.h. auch der Lage der Energieführungskette ist. So kann aus dem geometriesensitiven elektrischen Parameter eine Information über die aktuelle Lage der Energieführungskette gewonnen werden, insbesondere ein anormaler Verlauf, wie z.B. ein unerwünschtes Aufsteigen bzw. Aufbäumen des beweglichen Trums.

In einer solchen Ausführungsform kann der Indikatorleiter z.B. eine Empfängerspule bilden, die vorzugsweise mit dem beweglichen Trum verfahrbar ist. Dabei kann die Erfassungs-Schaltung nach einem Metalldetektor-Prinzip arbeiten. Vorzugsweise ist die Schaltung mitsamt der Empfängerspule und ggf. weiterer Spulen nach dem Prinzip eines BFO-Metalldetektor oder eines Puls-Induktions-Metalldetektors ausgeführt, deren Bauweise an sich dem Fachmann bekannt ist. Auch das Prinzip eines VLF-Metalldetektors wäre denkbar, hat jedoch eine geringere Reichweite.

Dabei kann insbesondere eine zusätzliche Senderspule in der Energieführungskette geführt sein, in welche der Generator das Anregungssignal einspeist, um ein messbares Signal im Indikatorleiter zu erzeugen. Dieses Signal kann dann von der Schaltung als Größe erfasst werden und einen Rückschluss auf die räumlichen Lage des Indikatorleiters erlauben.

Diese Lösungen sind gemäß den Maxwell-Gleichungen geometriesensitiv, z.B. einerseits aufgrund anderer elektromagnetisch wirksamer Bauteile im Umfeld der Energieführungskette (Randbedingungen), aber z.B. andererseits auch durch die von der aktuellen Relativposition und Raumlage der Trume zueinander abhängige Ein- oder Rückkopplung in die Empfängerspule d.h. den Indikatorleiter (vgl. Gegeninduktion), durch von der Raumgeometrie abhängige Selbstinduktion und ggf. auch durch eine Überlagerung der beiden vorgenannten positionsabhängigen Einwirkungen auf das elektromagnetische Feld.

Ungeachtet des Erfassungsprinzips kann vorgesehen sein, dass der Indikatorleiter eine Spule bildet und dass die Schaltung einen induktiven Parameter erfasst. Hierbei kann zumindest eine Spule, insbesondere die Empfängerspule und/oder Senderspule, in einem mitnehmernahen Längsabschnitt des beweglichen Trums verlaufen, um die letzte oben genannte Einwirkung zu verbessern. Alternativ oder ergänzend kann die Energieführungskette auch in einer ferromagnetischen Führungsrinne geführt sein, was die erste o.g. Einwirkung auf die am Indikatorleiter erfassbare Größe entspricht.

Um einen bezüglich der räumlichen Lage des Indikatorleiters aufgrund der Elektrodynamik geometriesensitiven Parameter als Größe zu erfassen, bestehen unterschiedliche Möglichkeiten, die z.B. auch an die Antennentechnik angelehnt sein können.

Es kann z.B. vorgesehen sein, dass der Indikatorleiter als Schleifenantenne angeordnet ist, insbesondere in der Energieführungskette, dass der Generator das Anregungssignal in den Indikatorleiter einspeist und dass die Schaltung einen antennengeometrie-sensitiven elektrischen Parameter, z.B. eine Resonanzfrequenz oder dgl., als Größe erfasst.

Alternativ kann der Indikatorleiter z.B. als Dipolantenne angeordnet sein, insbesondere in der Energieführungskette. Indem der Generator das Anregungssignal in einen derartigen Indikatorleiter einspeist kann die Schaltung ebenfalls einen antennengeometrie-sensitiven elektrischen Parameter als Größe erfassen, z.B. ein Stehwellenverhältnis (SWR), einen Reflexionsfaktor oder dgl. Hierzu geeignete Schaltungen, wie ein Stehwellenmessgerät (engl. SWR meter), ein Netzwerkanalysator usw. sind an sich bekannt.

In allen vorgenannten Ausführungsbeispielen wird eine Größe erfasst, die von der räumlichen Lage des Indikatorleiters und damit auch von zumindest einem Teil der Energieführungskette abhängt. Damit kann auf einfaches Weise eine Information über die aktuelle Lage bzw. Verfahr-Stellung der Energieführungskette, insbesondere durch Vergleich der Größe mit einem vorbestimmten angelernten Toleranzfeld, gewonnen werden.

Gemäß einem weiteren, unabhängigen zweiten Aspekt wird ein Überwachungssystem zur Zustandsüberwachung eines Kabels in einer Energieführungskette vorgeschlagen. Dieser Aspekt ist mit einem Überwachungssystem gemäß dem ersten Aspekt kombinierbar, u.a. da als Kernelement mindestens ein Indikatorleiter vorgesehen ist.

Gemäß dem zweiten Aspekt ist ein Überwachungssystem zur Zustandsüberwachung eines Kabels, das in einer Energieführungskette zwischen einer Basis und einem dazu relativbeweglichen Mitnehmer geführt ist, vorgesehen.

Der unabhängige zweite Aspekt betrifft die Zustandsüberwachung eines Kabels das in einer Energieführungskette zwischen einer Basis und einem dazu relativbeweglichen Mitnehmer geführt ist. Ein entsprechendes System kann eine gattungsgemäße Energieführungskette umfassen, die entlang eines Verfahrwegs verfahrbar ist und dabei ein meist bewegliches erstes Trum, ein meist ruhendes zweites Trum und zwischen beiden Trumen einen Umlenkbogen bildet. Ferner hat es insbesondere eine Überwachungsvorrichtung mit mindestens einem an der Energieführungskette angeordneten Geber, welche ein anhand des Gebers erzeugtes Signal auswertet um zu überwachen, ob im Betrieb der Energieführungskette ein Fehlerzustand auftritt. Der Geber kann dabei zwei von der Energieführungskette geführte elektrische Indikatorleiter aufweisen, die entlang einer überwiegenden Länge des beweglichen Trums oder z.B. der Gesamtlänge verlaufen und die Überwachungsvorrichtung kann eine Schaltung mit einer Messeinrichtung zur Widerstands- oder Leitwertmessung umfassen. Es kann vorgesehen werden, dass jeweils ein proximaler Endpunkt von jedem der beiden Indikatorleiter, d.h. die Endpunkte an einem der beiden Anschlussenden der Energieführungskette, mit der Messeinrichtung verbunden sind und die jeweils anderen bzw. distalen Endpunkte der beiden Indikatorleiter kurzgeschlossen sind. Diese Endpunkte der beiden Indikatorleiter können an einer bestimmten Längsposition der Energieführungskette enden oder vorzugsweise an dem anderen distalen Anschlussende der Energieführungskette. Durch den Kurzschluss können die Leiter eine Messschleife bilden, deren Widerstands- oder Leitwert durch die Messeinrichtung messbar ist. Denkbar ist z.B. eine durchgehende Messschleife ohne Unterbrechung durch ein gesonderte Kurzschlusskomponente, d.h. dass der eine Indikatorleiter die Strecke hin bzw. von proximal zu distal und der andere Indikatorleiter Strecke zurück bzw. umgekehrt darstellt. Eine separate Kurzschlusskomponente ist jedoch praxistauglicher, da dies die Verwendung bestehender mehradriger Kabel erlaubt und keine durchgehende Messschleife erfordert.

Der Kerngedanke dabei besteht soz. darin, dass die Schaltung eine Messeinrichtung zur Messung eines Widerstands- oder Leitwert des Indikatorleiters umfassen kann und dass der Indikatorleiter in Form einer Schleife ausgeführt sein kann, sodass einseitig an demselben Anschlussende der Energieführungskette gemessen werden kann. Zudem kann durch den Verlauf hin und zurück der gemessene Widerstandswert erhöht und die verschleißbedingte Einwirkung annähernd verdoppelt werden, was eine zuverlässige Früherkennung vor einem Ader- bzw. Litzenbruch vereinfacht.

Es kann ferner vorgesehen werden, dass die Überwachungsvorrichtung eine Auswertungseinheit umfasst, die eine integrierte Logikschaltung und einen Referenzwertspeicher aufweist. Dabei kann die Logikschaltung ein Ausgangssignal der Messeinrichtung erhalten und zum Vergleich mit mindestens einem vorgespeicherten Referenzwert aus dem Referenzwertspeicher nutzen.

Die Schaltung bzw. Messeinrichtung dazu kann insbesondere zur Spannungsmessung in Vierleitertechnik, ähnlich dem Prinzip einer Thomson-Brücke (auch Kelvin-Brücke genannt), ausgeführt sein mit einem in Vierleitertechnik eingebauten Referenzwiderstand, einem Differenzverstärker und einem Analog-Digital-Umsetzer ausgeführt sein, um auch kleinere Widerstandswerte einer Indikatorleitung präzise zu erfassen. Eine derartige Weiterbildung sieht z.B. vor, dass für die bzw. jede Messschleife ein eigener separater Instrumentenverstärker vorgesehen ist, welcher eingangsseitig mit beiden Endpunkten der Indikatorleiter verbunden ist, und ausgangsseitig mit einem Analog-Digital-Umsetzer, insbesondere einem in der Logikschaltung integrierten Analog-Digital-Umsetzer, verbunden ist. Vorzugsweise ist in Serie zu der bzw. den Messschleife(n) ein Referenzwiderstand geschaltet, wobei eine Konstantstrom-Quelle einen Messstrom durch die Messschleife(n) und ggf. Referenzwiderstand speist. Anhand des Referenzwiderstands kann die Spannungsmessung in Vierleitertechnik, ähnlich dem Prinzip einer Thomson-Brücke, auch einen sehr kleinen Widerstand der Messschleife aus den beiden Indikatorleitern hinreichend präzise erfassen.

Vorzugsweise ist die durch den zweiteilig hin- und zurückgeführten Indikatorleiter gebildete Messschleife anhand von zwei eigens dazu zweckbestimmten bzw. zugeordneten, zusätzlich Messadern in einem aktiven mehradrigen Versorgungskabel gebildet, dessen restliche Adern dem eigentlichen Versorgungszweck, z.B. der Datenübertragung oder Stromversorgung, dienen.

Die dedizierten Messadern sind vorzugsweise mittels einer Kurzschlusskomponente am mitnehmerseitigen Ende kurzgeschlossen und am basisseitigen Ende an die Messeinrichtung der Schaltung angeschlossen, d.h. die Schaltung und ggf. die Auswertungseinheit können einfach am stationären Teil der Anlage angeordnet sein. Die Beschaltung kann ggf. auch umgekehrt ausgeführt sein, wenn die Schaltung mitnehmerseitig vorgesehen ist, was insbesondere für ein am verfahrbaren Maschinenteil angeordnete Auswertungseinheit sinnvoll ist.

Für die Zustandsüberwachung eines Kabels ist es besonders vorteilhaft wenn die Messadern, welche den wesentlichen Teil der Indikatorleiter bilden, zusammen mit anderen aktiven Adern in einem im Betrieb bestimmungsgemäß eingesetzten Versorgungskabel verseilt oder ggf. verflochten sind. Hierdurch wird die Aussagekraft der Erfassung möglichst realitätsnah an die Abnutzung der eigentlich zu überwachenden aktiven Adern angeglichen. Dabei können die Messadern insbesondere baugleich zu mindestens einer im Betrieb aktiven Ader ausgeführt und auf analoge Weise wie diese verseilt bzw. eingeflochten sein. Insbesondere können die Messadern baugleich zu der auf Verschleiß anfälligsten Ader ausgeführt sein. Bei Leitungen mit einem großen Querschnitt ist es auch denkbar die Messadern mit kleinerem Leiterquerschnitt auszuführen und auf den Zustand einer stärkeren Hauptader zu interpolieren, insbesondere anhand der Auswertungseinheit.

Vorzugsweise hat die integrierte Logikschaltung oder, besonders bevorzugt, die Auswertungseinheit einen Bedieneingang zum Einspeichern eines bei Inbetriebnahme durch die Messeinrichtung gemessenen Widerstands- oder Leitwerts als Referenzwert. Dadurch kann auf einfache Weise auch durch den Endnutzer selbst der Normalwert für den ursprünglichen bzw. verschleißfreien Zustand der Messschleife bzw. der Indikatorleiter definiert werden. Hierdurch wird inhärent die Überwachungsvorrichtung anwendungsspezifisch programmiert, ohne dass z.B. die Länge der Energieführungskette oder ähnliche Daten bekannt sein müssen.

Insbesondere in Verbindung mit dem letztgenannten Merkmal ist es vorteilhaft wenn die Auswertungseinheit programmiert ist, um eine Warnmeldung auszulösen wenn der Widerstands- oder Leitwert des Indikatorleiters um einen vorbestimmten Betrag, insbesondere einen Betrag im Bereich von 15-25% des Referenzwerts, vom Referenzwert abweicht. Durch einen empirisch ermittelten Betrag als Schwellwert kann allein mit Kenntnis des ursprünglichen Normalwerts für den Widerstands- oder Leitwert die Kabelüberwachung erfolgen.

Für alle vorstehenden Aspekte, d.h. auch für Lageüberwachung und/oder Leitungszustandsüberwachung, sind die nachfolgenden Weiterbildungen vorteilhaft.

Die Auswertungseinheit weist vorzugsweise einen Speicher für Anwendungsdaten auf, und umfasst eine Logik, welche das von der Schaltung ausgegebene Signal abhängig von gespeicherten Anwendungsdaten auswertet. Diese Bauweise erlaubt z.B. das Anlernen von Nominalwerten oder eines Toleranzfelds. So können Referenzdaten z.B. in einem Initialisierungsprozess bei normalem, bestimmungsgemäß Verfahren einer neuen Energieführungskette mit der Schaltung aufgenommen und in der Auswertungseinheit gespeichert werden. Die anwendungs- und/oder lagespezifischen Referenzdaten können z.B. auch aus einem Testlabor gewonnen und in der Auswertungseinheit vorgespeichert oder zu dieser übertragen werden.

Insbesondere im letztgenannten Fall kann die Auswertungseinheit einen Eingang aufweisen, über den die aktuelle Position des Mitnehmers erfasst wird. Dies erlaubt es einen positionsabhängig aktuell geltenden Referenzwert aus dem Speicher zu lesen, was insbesondere für geometriesensitive Größen von Bedeutung ist.

Die Auswertungseinheit kann eine Kommunikationsschnittstelle, bspw. eine WLAN-Schnittstelle, zur Verbindung mit einem übergeordneten System umfassen, um Daten einzulesen oder zu senden, z.B. zur Initialisierung, zu Wartungszwecken oder zur Datensammlung beim Hersteller.

Insbesondere für eine präzise Messtechnische Erfassung ist es vorteilhaft wenn die Überwachungsvorrichtung einen Temperatursensor zur Temperaturnormierung aufweist. Dieser kann z.B. als Bestandteil einer modular ausgeführten Auswertungseinheit vorgesehen sein.

Zur Steigerung der Modularität kann die Vorrichtung, als Teil der Schaltung oder der Auswertungseinheit eine Logikschaltung aufweisen, insbesondere einen Mikrocontroller, ASIC, DSP oder dgl., welche die erfasste elektrische Größe digital verarbeitet, insbesondere zum Vergleich mit einem Referenzwert aus einem Referenzwertspeicher. Dies ist insbesondere vorteilhaft, wenn die Schaltung die elektrische Größe analog erfasst.

Die Schaltung kann im laufenden Betrieb der Energieführungskette die elektrische Größe zeitkontinuierlich oder zeitdiskret in gleichmäßigen oder zufälligen Zeitabständen erfassen. Hierbei ist vorzugsweise ein Filter, insbesondere ein Mittelwert- oder Spitzenfilter, in der Schaltung oder der Auswertungseinheit vorgesehen, um irrelevante Schwankungen z.B. durch elektromagnetische Störungen und dgl. herauszufiltern.

Die Vorrichtung kann, insbesondere als Modul, ortsfest an der Basis angeordnet sein, wobei der Indikatorleiter einseitig am Anschlussende für die Basis an die Schaltung angeschlossen ist.

Das Grundprinzip des hier vorgeschlagenen Überwachungssystems eignet sich für den laufenden Betrieb, sowohl zur Verwendung zur Überwachung des räumlichen Verlaufs der Energieführungskette im laufenden Betrieb als auch zur Zustandsüberwachung eines Datenoder Stromversorgungskabels einer Energieführungskette im fortdauernden Betrieb. Die Systeme dienen insbesondere präventiver Wartung und/oder der Sicherheitsabschaltung.

Weitere vorteilhafte Merkmale und Wirkungen der Erfindung werden im Folgenden anhand einiger bevorzugter Ausführungsbeispiele unter Bezugnahme auf die beigefügten Zeichnungen näher erläutert. Dabei zeigen:
**FIG.1A-1B****:** als Prinzipskizze in Seitenansicht (FIG.1A) und schematischem Querschnitt (FIG.1B) ein erstes Ausführungsbeispiel eines Überwachungssystems gemäß einem Aspekt;
**FIG.2A-2B****:** als Prinzipskizze in Seitenansicht (FIG.2A) und schematischem Querschnitt (FIG.2B) ein zweites Ausführungsbeispiel eines Überwachungssystems gemäß einer Variante;
**FIG.3****:** ein Schema eines Toleranzfelds innerhalb dessen eine an am Indikatorleiter elektrische Größe liegen soll;
**FIG.4****:** als Prinzipskizze in Seitenansicht ein drittes Ausführungsbeispiel eines Überwachungssystems;
**FIG.5****:** als Prinzipskizze in Seitenansicht ein viertes Ausführungsbeispiel eines Überwachungssystems gemäß einer weiteren Variante, mit einer drahtlosen Kommunikationsschnittstelle zu einem Kommunikationsmodul;
**FIG.6A-6B****:** als Prinzipskizze in Seitenansicht (FIG.6A) ein Überwachungssystem mit drahtloser Kommunikationsschnittstelle zu einem Kommunikationsmodul, und als separates Schaltungsmodul (FIG.6B) zur Zustandsüberwachung eines Kabels das in einer Energieführungskette; und
**FIG.7****:** ein Foto eines teilweise freigelegten elektrischen Versorgungskabels mit verseilten Adern.

In allen Zeichnungen bezeichnen gleiche Bezugszeichen Merkmale mit gleichwertiger Beschaffenheit oder Wirkung. Zur Erleichterung werden Wiederholungen vermieden.

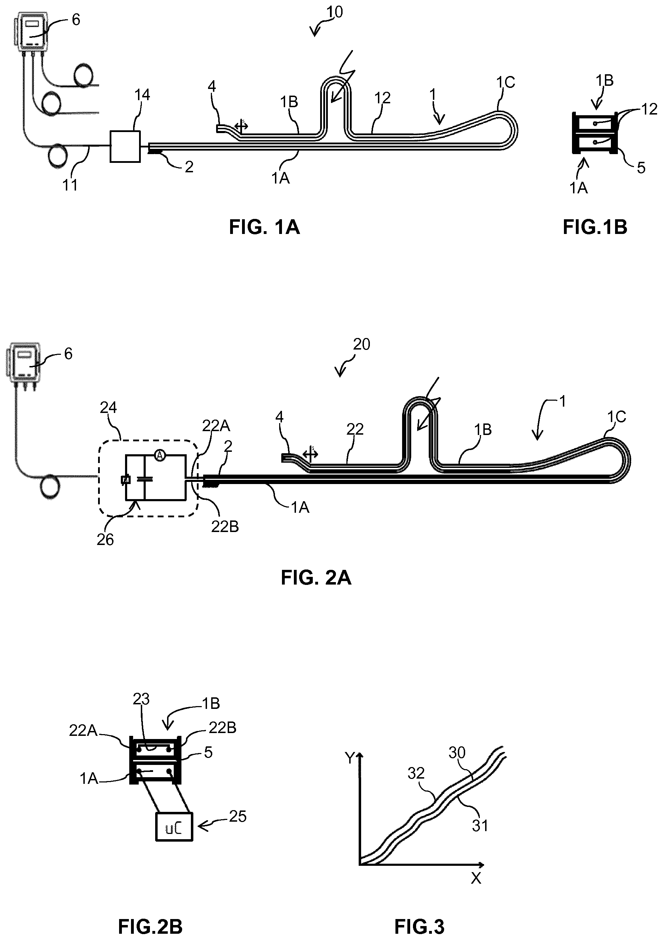

In den FIG.1-7 ist eine Energieführungskette, allgemein mit 1 bezeichnet, gezeigt mit einem liegenden stationären Trum 1A, bei horizontaler Anordnung auch Untertrum genannt, einen beweglichen Trum 1B, bei horizontaler Anordnung auch Obertrum genannt, sowie mit - als ortsvariablem Übergang dazwischen - einem verfahrbaren, etwa U-förmigen Umlenkbogen 1C der einen vordefinierten Krümmungsradius gewährleistet. Hier ist eine sog. "gleitende", d.h. nicht freitragende Energieführungskette 1 für lange Verfahrwege, typisch >3m gezeigt. Bei derartigen Energieführungsketten 1 kann das bewegliche Trum 1B auf dem stationären Trum 1A abgleiten oder abrollen. An sich bekannte Gleitkufen oder Gleitrollen sind nicht gezeigt. Dabei ist der vordefinierte Krümmungsradius des Umlenkbogens 1C, zum Schutz der geführten Leitungen (nicht gezeigt), deutlich größer als der Kontaktabstand zwischen den Trumen 1A, 1B. Die Erfindung eignet sich jedoch prinzipiell auch für freitragende Energieführungsketten oder vertikale Anwendungen (nicht gezeigt).

Der Endbereich des stationären Trums 1A bildet eine erste Anschlussstelle der Energieführungskette 1 und ist an einer zur Umgebung raumfesten Basis befestigt, welche den Festpunkt 2 der Energieführungskette 10 bildet. Der Endbereich des beweglichen Trums 1B bildet eine zweite Anschlussstelle der Energieführungskette 1 und ist an einem Mitnehmer 4 befestigt, der relativ zum Festpunkt 2 beweglich ist, nämlich mit dem zu versorgenden, bewegenden Teil, z.B. von einer Industriemaschine oder -Anlage verbunden ist.

In an sich bekannter Weise bewegt sich der Mitnehmer 4, gemäß den in FIG.1-7 eingezeichneten Doppelpfeilen in eine Vorwärts- und Rückwärtsrichtung und zieht bzw. schiebt dabei die Energieführungskette 1. In FIG.1-7 ist der Mitnehmer 4 und damit die Stellung der Energieführungskette 10 rein beispielhaft, nur zur Veranschaulichung als Momentaufnahme bzw. augenblickliche Zwischenpositionen dargestellt. Die Energieführungskette 1 ist für eine quasi ebene Bewegung entlang der Vorwärts- und Rückwärtsrichtung, d.h. mit parallel bleibenden Trumen 1A, 1B gestaltet und besteht im Wesentlichen aus Kettengliedern (nicht näher gezeigt) die z.B. um senkrecht zur Ebene der FIG.1-7 schwenkbare parallele Schwenkachsen gegeneinander abwinkelbar sind. Die Energieführungskette 1 kann bei allen Ausführungsformen in einer in FIG.1B schematisch näher gezeigten Führungsrinne 5 seitlich geführt sein.

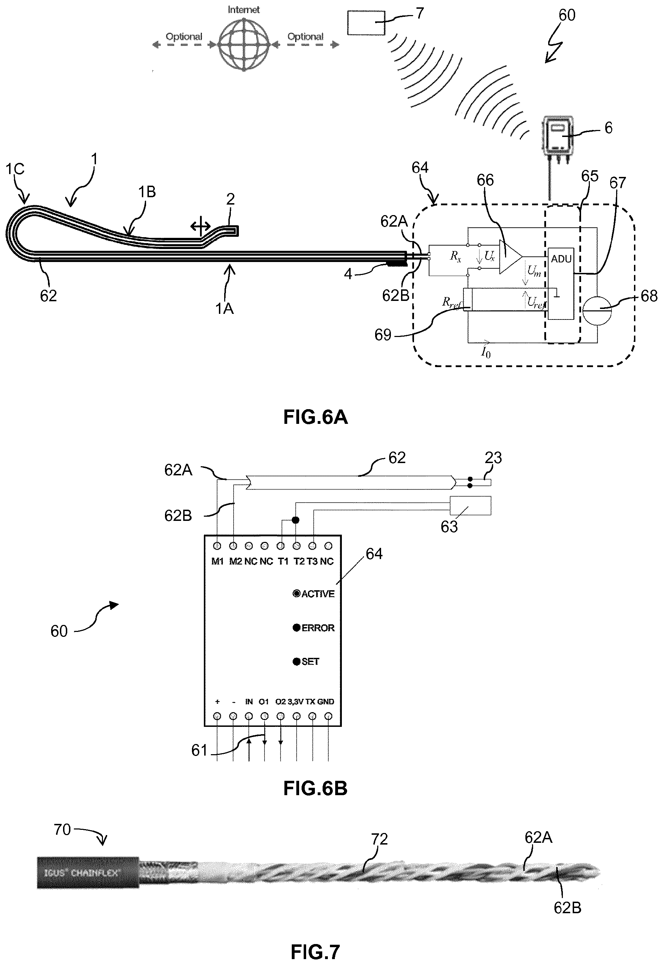

Einen seltenen aber besonders bei langen oder schnell fahrenden Energieführungsketten 1 möglichen Fehlerzustand (als "Blitz" angedeutet) zeigen hier rein schematisch und in übertriebener Darstellung nur FIG.1A und FIG.2A, wobei ein Teilbereich des beweglichen Trums 1B in unerwünschter Weise aufsteigt. FIG.6A zeigt beispielhaft einen normalen Verlauf der Energieführungskette 1.

Im Ausführungsbeispiel nach FIG.1A-1B ist ein Überwachungssystem 10 mit einem entlang der beiden Trume 1A, 1B und durch den Umlenkbogen 1C der Energieführungskette 1 geführten elektrischen Indikatorleiter 12 als Kernelemente des Gebers gezeigt. Der einzige Indikatorleiter 12 ist als Dipolstrahler bzw. Dipolantenne angeordnet und lediglich am Endknoten an der Basis 2 mit einer Schaltung 14 verbunden. Die Schaltung 14 umfasst einen Signalgenerator der ein hochfrequentes Anregungssignal, z.B. ein Wechselstrom-Sinussignal mit einer Frequenz von einigen Mhz in den Indikatorleiter 12 speist. Ferner hat die Schaltung 14 einen SWR-Meter (nicht gezeigt), welcher anhand des Indikatorleiters 12 das Stehwellenverhältnis (SWR) als elektrische Größe erfasst. Das SWR ist von der Raumlage des Indikatorleiters 12 und damit der Energieführungskette 1, insbesondere des beweglichen Trums 1B abhängig. Die Erfassung des SWR erlaubt es, einen Fehlerzustand (als "Blitz" angedeutet) durch Vergleich mit einem bei Inbetriebnahme angelernten Sollverlauf des SWR (vgl. 30 in FIG.3) zu erkennen. Anstelle des SWR-Meter kann z.B. auch ein Netzwerkanalysator oder eine einfachere Schaltung für die Messung der reflektierten Welle bei gleichbleibender Anregungsfrequenz geeignet. Die Schaltung 14 ist ausgangsseitig mit einer Auswertungseinheit 6 verbunden, die z.B. ein das SWR anzeigendes Ausgangssignal der Schaltung 14 auswertet und bei Fehlerzustand frühzeitig einen Notstopp auslöst.

In der Variante nach FIG.2A-2B bildet der Indikatorleiter 22 eine Messschleife bzw. Schleifenantenne und ist als induktiver Teil eines RLC Schwingkreis in der Schaltung 24 angeordnet. Die beiden Endpunkte von zwei Messadern 22A, 22B an der Basis 2 sind unmittelbar mit den restlichen Komponenten des Schwingkreis der Schaltung 24 verbunden. Die distalen Endpunkte, z.B. am Mitnehmer 4, sind anhand einer niederohmigen Kurzschlusskomponente 23 kurzgeschlossen, wie in FIG.2B gezeigt. Da die Induktion auch hier geometrieabhängig ist, kann die Schaltung 24 eine Veränderung der Spuleninduktion der Messschleife als Messwert 30 im Vergleich zu einem Normalverlauf zwischen zwei Toleranzkurven 31, 32, wie in FIG.3 schematisch angedeutet erkennen. Dies kann durch einen Mikrocontroller 25 als Teil der Schaltung 24 oder in der Auswertungseinheit 6 erfolgen, z.B. durch Erkennen eines anormalen Sprungs in der erfassten elektrischen Größe des zweiteiligen Indikatorleiters 22.

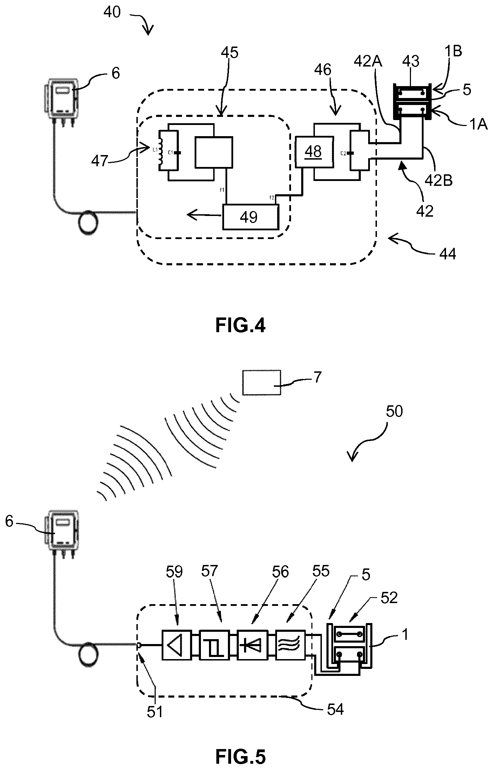

FIG.4 zeigt eine Variante des Überwachungssystems 40 zur Erfassung einer unerwarteten Veränderung in der Schwebungsfrequenz durch Überlagerung aus zwei Schwingkreisen. Der Indikatorleiter 42 bildet auch hier eine Schleife bzw. Spule aus zwei Messadern 42A, 42B, die von der Basis 2 bis zum Mitnehmer 4 in der Energieführungskette mitgeführt sind und am Mitnehmer durch die Kurzschlusskomponente 43 gebrückt sind.

Die Schaltung bildet einen ersten Messschwingkreis 46, mit einem Kondensator (C2) und der Messschleife 42 als Induktivität, der durch einen Signalgenerator 48 mit einem Sinussignal beaufschlagt wird. Ein Referenzschwingkreis 47 simuliert abhängig von einem Messlauf bzw. Teaching bei Inbetriebnahme das Normalverhalten des Messschwingkreis 46 bei bestimmungsgemäßen Verlauf der der Energieführungskette 1, wobei dessen Verhalten von der Position des Mitnehmers 4 abhängig ist. Die Simulation kann z.B. durch eine eingespeicherte Messwertfolge oder einen einstellbaren Oszillator in einem Mikrocontroller 45 realisiert werden. Anhand einer Mischerstufe 49 wird dann eine Schwebungsfrequenz ausgehend von der am Messschwingkreis 46 erfassten Schwingung und der lageabhängig simulierten Schwingung des Referenzschwingkreis 47 erzeugt. Anschließend erfolgt ein Vergleich der von der Mischerstufe 49 generierten bzw. simulierten Schwebungsfrequenz, z.B. mit einem von der Position X des Mitnehmers 4 abhängigen Toleranzfeld 31, 32 wie in FIG.3 schematisch gezeigt. Diese Variante ist, z.B. an das Prinzip eines Metalldetektors angelehnt, und kann insbesondere mit einer Führungsrinne 5 aus ferromagnetischem Stahlblech oder dgl. eingesetzt werden.

In einer nicht näher gezeigten Variante kann nebst der Messschleife aus den Messadern 42A, 42B auch eine separate Anregungs- bzw. Sendespule vorgesehen werden, z.B. nach dem Prinzip anderer Metalldetektortypen.

FIG.5 zeigt ein induktiv erfassendes weiteres Überwachungssystem 50 wobei die Führungsrinne 5 ähnlich eines "Ferritkerns" wirkt. Der schleifenförmige Indikatorleiter 52 wird durch einen Oszillator 55 als Signalgenerator angeregt und ausgemessen. Ein Demodulator 56 führt das erfasste Signal zu einem Diskriminator bzw. Hysterese-Komparator 57, und dieser weiter zu einer Endstufe, welche ein Ausgangssignal 51 für die Auswertungseinheit 6 bereitstellt. Angelernte Normalwerte bzw. Toleranzkurven 31, 32 können hierbei bei Inbetriebnahme oder über eine Datenverbindung wie z.B. WLAN mit einem Kommunikationsmodul 7 in die Auswertungseinheit 6 eingespeichert werden.

Die vorstehend beschriebenen Überwachungssysteme 10, 30, 40, 50 erlauben insbesondere anhand elektromagnetischer Wechselwirkung die Erkennung einer Lageabweichung der Energieführungskette 1 von ihrem nominalen Sollverlauf.

Nachfolgend wird ein unabhängiger weiterer Aspekt beschreiben, nämlich ein System 60 zur Verschleißüberwachung von elektrischen Leitern bzw. Adern in einem Versorgungskabel einer aktiven Energieführungskette um frühzeitig vor einem anstehenden Kabelbruch zu warnen.

Das Schaltungsmodul 64 verfügt über zwei Statusanzeigen z.B. (ACTIVE, ERROR: FIG.6B) und einen Taster (SET: FIG.6B) zum Einprogrammieren eines nominalen Widerstandswerts in ein Speicherregister in einem Mikrocontroller 65 des Schaltungsmoduls 64.

Ein Instrumenten- bzw. Differenzverstärker (OpAmp) 66 ist unmittelbar an die Endknoten von zwei Messadern 62A, 62B angeschlossen, die einen schleifenförmigen Indikatorleiter 62 in der Energieführungskette 1 bilden, der am Mitnehmer 4 über eine Komponente 23 kurzgeschlossen ist. Der Ausgang des Instrumentenverstärkers 66 ist mit dem Eingang eines A/D-Umsetzer-Block 67 im Mikrocontroller 65 verbunden, der an zwei weiteren Eingängen einen Spannung eines Referenzwiderstands 69 abgreift. Die in Serie geschalteten Messadern 62A, 62B sind mit dem Referenzwiderstands 69 (Rref) in Serie geschaltet und werden durch eine Referenz-Gleichstromquelle 68 (constant current source) des Schaltungsmoduls 64 mit einem konstanten Strom (I0) versorgt. Die Eingänge des ADU 67 erfassen einerseits die über die Messschleife 62A, 62B abfallende Messspannung um anhand des Stroms (I0) deren relativ kleinen ohmschen Serienwiderstand Rx zu bestimmen und andererseits nach dem Vierleiter-Messprinzip die Spannung am Referenzwiderstand 69 (Rref), aus deren Verhältnis der zu messende Widerstand Rx mit dem Mikrocontroller 65 präzise bestimmt wird.

Es können zur Steigerung der Erfassungssicherheit auch mehrere Messschleifen 62A, 62B jeweils über einen eigenen Differenzverstärker 66 und entsprechenden Eingang des ADU 67 ausgemessen werden. Alternativ zum Widerstandswert kann natürlich gleichwertig auch ein Leitwert ermittelt werden. An den Klemmen M1 und M2 (FIG.6B) des Schaltungsmoduls 64 wird die Messleitung, d.h. je ein proximaler Endknoten der Messadern 62A, 62B nahe der Basis 2, angeschlossen. Die beiden distalen Endknoten der Messadern 62A, 62B werden kurzgeschlossen bzw. niederohmig miteinander verbunden. Zu Normierungszwecken ist ein Temperatursensor 63 an das Schaltungsmodul 64 (Klemmen T2 und T3) angeschlossen.

Der Mikrocontroller 65 lässt die ACTIVE LED grün leuchten, sobald das Schaltungsmoduls 64 (über die Klemmen + und -) an eine Spannungsversorgung (z.B. 24V DC) angeschlossen wird und der Referenzwert einprogrammiert ist. Der Referenzwert wird bei Inbetriebnahme einmalig durch Betätigung des SET-Tasters in den Mikrocontroller 65 programmiert, durch intiale Messung über den Instrumentenverstärker 66 wie oben.

Die grüne und rote Error LED leuchten auf, sobald der vom Mikrocontroller 65 gemessene Widerstandswert Rx der Leitung einen vorbestimmten Warnschwellwert (z.B. 1,25 x Rx) überschritten hat. Der Warnschwellwert kann empirisch aus Lebensdauerversuchen ermittelt werden und ggf. auch nachträglich, z.B. über das Kommunikationsmodul 7 geändert bzw. aktualisiert werden. Ferner kann der Mikrocontroller 65 über einen Ausgang durch ein Relais (nicht gezeigt) einen Warnmeldekontakt (O1) schließen.

Wenn ein Kabelbruch aufgetreten ist (Rx gegen unendlich), geht z.B. die grüne LED aus und nur die rote Error LED leuchtet. Zusätzlich schließt der Mikrocontroller 65 dann einen weiteren potentialfreie Fehlerkontakt (O2).

Vorzugsweise wird die Warnmeldung über eine Kommunikationsschnittstelle z.B. ein Industriebus, RS-232 oder dgl. (3,3V, TX, GND) an die hier optionale Auswertungseinheit 6 oder unmittelbar an ein internetfähiges Kommunikationsmodul 7 übertragen werden.

Über die Kommunikationsschnittstelle (3,3V, TX, GND) des Schaltungsmoduls 64 kann der Mikrocontroller 65 erfasste Messdaten (Widerstandswert, Konstantstrom, Spannungsabfall, Temperatur etc.) an die optionale Auswertungseinheit 6 oder unmittelbar an das Kommunikationsmodul 7 übertragen. Das Schaltungsmodul 64 kann alternativ oder zusätzlich einen Datenlogger (z.B. für eine Mikro SD-Karte) zur Messdatenspeicherung aufweisen. Ferner können Sensoreingänge als Zyklenzähler bzw. zur Positionserfassung (z.B. nach FIG.1-5) vorgesehen sein. In der Programmierung des Mikrocontrollers 65 kann ein Softwarefilter realisiert sein, um Störeinflüsse z.B. durch elektormagnetische Wechselwirkung mit anderen aktiven Leitungen, herauszufiltern. Die Messung des Widerstands der Messadern 62A, 62B kann periodisch z.B. im Abstand von wenigen Minuten oder in quasi-zufälligen Zeitintervallen erfolgen um Artefakte z.B. durch Oberwellen und dgl. zu vermeiden.

FIG.7 zeigt rein beispielhaft zur Veranschaulichung wie Messadern 62A, 62B zusammen mit aktiven Versorgungsadern in einem Versorgungskabel 70 mitverseilt sind, wobei die Messadern 62A, 62B baugleich zu mindestens anderen im Betrieb aktiven Versorgungsadern sind.

### Bezugszeichenliste

FIG.1-6
   - 1: Energieführungskette
   - 1A: Stationäres Trum
   - 1B: Bewegliches Trum
   - 1C: Umlenkbogen
   - 2: Festpunkt
   - 4: Mitnehmer
   - 5: Führungsrinne
   - 6: Auswertungseinheit
   - 7: Kommunikationsmodul
FIG.1A-1B
   - 10: Überwachungssystem
   - 11: Signal
   - 12: Indikatorleiter
   - 14: Schaltung
FIG.2A-2B
   - 20: Überwachungssystem
   - 22: Indikatorleiter
   - 22A, 22B: Messader
   - 23: Kurzschlusskomponente
   - 24: Schaltung
   - 25: Mikrocontroller
   - 26: Schwingkreis
FIG.3
   - X: Position des Mitnehmers
   - Y: Betrag (der elektrischen Größe)
   - 30: Messwert (der elektrischen Größe)
   - 31: untere Toleranzkurve
   - 32: obere Toleranzkurve
FIG. 4
   - 40: Überwachungssystem
   - 42: Indikatorleiter
   - 42A, 42B: Messader
   - 43: Kurzschlusskomponente
   - 44: Schaltung
   - 45: Mikrocontroller
   - 46: Messschwingkreis
   - 47: Referenzschwingkreis (simuliert)
   - 48: Signalgenerator
   - 49: Mischerstufe
FIG.5
   - 50: Überwachungssystem
   - 51: Signal
   - 52: Indikatorleiter
   - 54: Schaltung
   - 55: Oszillator (Signalgenerator)
   - 56: Demodulator
   - 57: Komparator
   - 59: Endstufe
FIG. 6
   - 60: Überwachungssystem
   - 61: Signal
   - 62: Indikatorleiter (Rx)
   - 62A, 62B: Messadern
   - 63: Tempertursensor
   - 64: Schaltungsmodul
   - 65: Mikrocontroller
   - 66: Differenzverstärker
   - 67: A/D-Umsetzer
   - 68: Stromquelle
   - 69: Referenzwiderstand (Rref)
FIG. 7
   - 70: elektrisches Versorgungskabel
   - 72: aktive Adern
   - 62A, 62B: Messadern

## Patentansprüche

1. **Überwachungssystem** zur Lageüberwachung einer Energieführungskette (1) zum Führen mindestens einer Leitung zwischen einer Basis und einem dazu relativbeweglichen Mitnehmer (4), umfassend:
- eine Energieführungskette (1) die entlang eines Verfahrwegs verfahrbar ist und dabei ein bewegliches Trum (1B) mit einem Anschlussende für den Mitnehmer (4), ein ruhendes Trum (1A) mit einem Anschlussende für die Basis und zwischen beiden Trumen (1A; 1B) einen Umlenkbogen 1C) bildet; und
- eine Überwachungsvorrichtung mit mindestens einem an der Energieführungskette (1) angeordneten Geber, welche ein anhand des Gebers erzeugtes Signal (11; 51) auswertet, um zu überwachen, ob im Betrieb der Energieführungskette (1) ein Fehlerzustand auftritt; wobei der Geber einen von der Energieführungskette (1) geführten elektrischen Indikatorleiter (12; 22; 42; 52) aufweist, der zumindest entlang einer überwiegenden Länge des beweglichen Trums (1B) verläuft;
- die Überwachungsvorrichtung eine mit dem Indikatorleiter (12; 22; 42; 52) verbundene Schaltung (14; 24; 44; 54) umfasst, welche anhand des Indikatorleiters (12; 22; 42; 52) eine elektrische Größe erfasst; **dadurch gekennzeichnet, dass** das Überwachungssystem ferner einen Generator (48; 55) aufweist, der ein zeitvariables Anregungssignal, insbesondere ein Wechselstrom- oder Impulssignal, erzeugt, und die Schaltung (14; 24; 44; 54) am Indikatorleiter (12; 22; 42; 52) einen bezüglich der räumlichen Lage des Indikatorleiters (12; 22; 42; 52) geometriesensitiven elektrischen Parameter als Größe erfasst.

2. Überwachungssystem nach Anspruch 1, **dadurch gekennzeichnet, dass** der Indikatorleiter eine Empfängerspule (42A, 42B) bildet, die vorzugsweise mit dem beweglichen Trum (1B) verfahrbar ist, und die Schaltung (44) nach einem Metalldetektor-Prinzip arbeitet.

3. Überwachungssystem nach Anspruch 2, **dadurch gekennzeichnet, dass** eine zusätzliche Senderspule in der Energieführungskette (1) geführt ist, in welche der Generator das Anregungssignal einspeist.

4. Überwachungssystem nach Anspruch 1, 2 oder 3, **dadurch gekennzeichnet, dass** der Indikatorleiter (22; 42; 52) eine Spule bildet und dass die Schaltung einen induktiven Parameter erfasst; wobei
- zumindest eine Spule, insbesondere die Empfängerspule und/oder Senderspule, in einem mitnehmernahen Längsabschnitt des beweglichen Trums (1B) verläuft und/oder
- die Energieführungskette (1) in einer ferromagnetischen Führungsrinne (5) geführt ist.

5. Überwachungssystem nach Anspruch 1, **dadurch gekennzeichnet, dass** der Indikatorleiter (22) als Schleifenantenne angeordnet ist, dass der Generator das Anregungssignal in den Indikatorleiter (22) einspeist und dass die Schaltung (24) einen bezüglich der Antennengeometrie sensitiven elektrischen Parameter als Größe erfasst.

6. Überwachungssystem nach Anspruch 1, **dadurch gekennzeichnet, dass** der Indikatorleiter (12) als Dipolantenne angeordnet ist, dass der Generator das Anregungssignal in den Indikatorleiter (12) einspeist und dass die Schaltung (14) einen bezüglich der Antennengeometrie sensitiven elektrischen Parameter als Größe erfasst.

7. Überwachungssystem nach einem der Ansprüche 1 bis 6, **dadurch gekennzeichnet, dass** die Überwachungsvorrichtung eine mit der Schaltung verbundene Auswerteeinheit umfasst.

8. Überwachungssystem nach Anspruch 7, **dadurch gekennzeichnet, dass** die Auswertungseinheit (6) einen Speicher für Anwendungsdaten aufweist, und eine Logik umfasst, welche das von der Schaltung (14; 24; 44; 54; 64) ausgegebene Signal abhängig von gespeicherten Anwendungsdaten auswertet.

9. Überwachungssystem nach einem der Ansprüche 7 bis 8, **dadurch gekennzeichnet, dass** die Auswertungseinheit (6) eine Kommunikationsschnittstelle zur Verbindung mit einem übergeordneten System (7) umfasst.

10. Überwachungssystem nach einem der Ansprüche 1 bis 9, **dadurch gekennzeichnet, dass** die Überwachungsvorrichtung einen Temperatursensor (63) zur Temperaturnormierung aufweist.

11. Überwachungssystem nach einem der Ansprüche 1 bis 10, **dadurch gekennzeichnet, dass** eine Logikschaltung (25; 45; 65) vorgesehen ist, insbesondere einen Mikrocontroller, ASIC, DSP oder dgl., welche die erfasste elektrische Größe digital verarbeitet, insbesondere zum Vergleich mit einem Referenzwert aus einem Referenzwertspeicher.

12. Überwachungssystem nach einem der Ansprüche 7 bis 11, **dadurch gekennzeichnet, dass** die Schaltung (14; 24; 44; 54; 64) im laufenden Betrieb der Energieführungskette (1) zeitkontinuierlich oder zeitdiskret die elektrische Größe erfasst und ein Filter, insbesondere ein Mittelwert- oder Spitzenfilter, in der Schaltung (14; 24; 44; 54; 64) oder der Auswertungseinheit (6) vorgesehen ist.

13. Überwachungssystem nach einem der Ansprüche 1 bis 12, **dadurch gekennzeichnet, dass** die Überwachungsvorrichtung (10; 20; 40; 50; 60) als Modul ortsfest an der Basis (2) angeordnet ist und der bzw. die Indikatorleiter (12; 22; 42; 52; 62) einseitig am Anschlussende für die Basis (2) an die Schaltung (14; 24; 44; 54; 64) angeschlossen ist bzw. sind.

14. Verwendung eines Überwachungssystems (10; 20; 40; 50) nach einem der Ansprüche 1 bis 13 zur Überwachung des räumlichen Verlaufs der Energieführungskette (1) im laufenden Betrieb.

## Claims

1. A monitoring system for position monitoring of an energy guide chain (1) for guiding at least one line between a base and a moving end (4) movable relative thereto, comprising:
- an energy guide chain (1) which is displaceable along a travel path and, in so doing, forms a mobile run (1B) with a connection end for the moving end (4), a stationary run (1A) with a connection end for the base and a deflection arc (1C) between the two runs (1A; 1B); and
- a monitoring device with at least one sensing component arranged on the energy guide chain (1), which monitoring device evaluates a signal (11; 51) generated using the sensing component in order to monitor the occurrence of a fault condition during operation of the energy guide chain (1), wherein
- the sensing component includes an electrical indicator conductor (12; 22; 42; 52) guided by the energy guide chain (1) and extending along the greater part of the length of the mobile run (1B);
- the monitoring device comprises a circuit (14; 24; 44; 54) connected to the indicator conductor (12; 22; 42; 52), which circuit detects an electrical quantity using the indicator conductor (14; 24; 44; 54) **characterised in that** the monitoring system includes a generator (48; 55) which generates a time-variant excitation signal, in particular an alternating current or pulse signal, and the circuit (14; 24; 44; 54) detects at the indicator conductor (14; 24; 44; 54) as quantity an electrical parameter which is geometry-sensitive in relation to the spatial position of the indicator conductor (14; 24; 44; 54) .

2. The monitoring system according to Claim 1, **characterised in that** the indicator conductor forms a receiver coil (42A, 42B), which is preferably displaceable with the mobile run (1B), and the circuit (44) operates according to a metal detector principle.

3. The monitoring system according to Claim 2, **characterised in that** an additional transmit coil, into which the generator feeds the excitation signal is guided in the energy guide chain (1).

4. The monitoring system according to Claim 1, 2 or 3, **characterised in that** the indicator conductor (22; 42; 52) forms a coil and **in that** the circuit detects an inductive parameter, wherein
- at least one coil, in particular the receiver coil and/or transmit coil, extends in a portion of the length of the mobile run (1B) close to the moving end and/or
- the energy guide chain (1) is guided in a ferromagnetic guide channel (5).

5. The monitoring system according to Claim 1, **characterised in that** the indicator conductor (22) is arranged as a loop antenna, **in that** the generator feeds the excitation signal into the indicator conductor (22) and **in that** the circuit (24) detects as quantity an electrical parameter which is sensitive in relation to the antenna geometry.

6. The monitoring system according to Claim 1, **characterised in that** the indicator conductor (12) is arranged as a dipole antenna, **in that** the generator feeds the excitation signal into the indicator conductor (12) and **in that** the circuit (14) detects as quantity an electrical parameter which is sensitive in relation to the antenna geometry.

7. The monitoring system according to one of Claims 1 to 6, **characterised in that** the monitoring device comprises an evaluation unit (6) connected to the circuit (14; 24; 44; 54) .

8. The monitoring system according to Claim 7, **characterised in that** the evaluation unit (6) includes a memory for application data and comprises a logic circuit which evaluates the signal output by the circuit (14; 24; 44; 54; 64) in dependence on stored application data.

9. The monitoring system according to one of Claims 7 to 8, **characterised in that** the evaluation unit (6) comprises a communication interface for connection to a higherlevel system (7).

10. The monitoring system according to one of Claims 1 to 9, **characterised in that** the monitoring device includes a temperature sensor (63) for temperature normalisation.

11. The monitoring system according to one of Claims 1 to 10, **characterised in that** a logic circuit (25; 45; 65) is provided, in particular a microcontroller, ASIC, DSP or the like, which digitally processes the detected electrical quantity, in particular for comparison with a reference value from a reference value memory.

12. The monitoring system according to one of Claims 7 to 10, **characterised in that**, during operation of the energy guide chain (1), the circuit (14; 24; 44; 54; 64) detects the electrical quantity continuously or in timediscrete manner and a filter, in particular an average or peak filter, is provided in the circuit (14; 24; 44; 54; 64) or the evaluation unit (6).

13. The monitoring system according to one of Claims 1 to 12, **characterised in that** the monitoring device (10; 20; 40; 50; 60) is arranged as a module stationarily on the base (2) and the indicator conductor(s) (12; 22; 42; 52; 62) is/are connected single-endedly to the circuit (14; 24; 44; 54; 64) at the connection end for the base (2) .

14. Use of a monitoring system (10; 20; 40; 50) according to one of Claims 1 to 13, for monitoring the spatial course of the energy guide chain (1) in ongoing operation.

## Revendications

1. Système de surveillance pour surveiller la position d'une chaîne de guidage d'énergie (1) pour guider au moins une ligne entre une base et un entraîneur (4) mobile par rapport à celle-ci, comprenant:
- une chaîne de guidage d'énergie (1) qui est mobile le long une course de déplacement et qui forme ainsi un brin mobile (1B) avec une extrémité de connexion pour l'entraîneur (4), un brin stationnaire (1A) avec une extrémité de connexion pour la base et qui forme un arc de déviation (1C) entre les deux brins (1A; 1B); et
- un dispositif de surveillance avec au moins un capteur disposé sur la chaîne de guidage d'énergie (1), qui évalue un signal (11; 51) généré sur la base du capteur afin de surveiller si une condition de défaut apparaît dans le fonctionnement de la chaîne de guidage d'énergie (1); dans lequel ledit capteur comprend un conducteur indicateur électrique (12; 22; 42; 52) guidé par ladite chaîne de guidage d'énergie (1) et s'étendant au moins le long d'une longueur prédominante de ladite brin mobile (1B);
- le système de surveillance comprenant un circuit (14; 24; 44; 54) connecté au conducteur indicateur (12; 22; 42; 52) qui détecte une quantité électrique au moyen du conducteur indicateur (12; 22; 42; 52); **caractérisé en ce que** le système de surveillance comprend en outre un générateur (48; 55) qui génère un signal d'excitation variable dans le temps, en particulier un courant alternatif ou un signal d'impulsion, et **en ce que** le circuit (14; 24; 44; 54) détecte sur le conducteur indicateur (12; 22; 42; 52) un paramètre électrique qui est sensible à la géométrie par rapport à la position spatiale du conducteur indicateur (12; 22; 42; 52) en tant que variable.

2. Système de surveillance selon la revendication 1, **caractérisé en ce que** le conducteur indicateur forme une bobine réceptrice (42A, 42B) qui est de préférence mobile avec le brin mobile (1B), et le circuit (44) fonctionne selon un principe de détecteur de métaux.

3. Système de surveillance selon la revendication 1, **caractérisé en ce qu'**une bobine émettrice supplémentaire est guidée dans la chaîne de guidage d'énergie (1), dans laquelle le générateur alimente le signal d'excitation.

4. Système de surveillance selon la revendication 1, 2 ou 3, **caractérisé en ce que** le conducteur indicateur (22; 42; 52) forme une bobine et que le circuit détecte un paramètre inductif; où
- au moins une bobine, en particulier la bobine réceptrice et/ou la bobine émettrice, s'étend dans une partie longitudinale du brin mobile (1B) à proximité de l'entraîneur et/ou
- la chaîne de guidage d'énergie (1) est guidée dans une rainure de guidage ferromagnétique (5).

5. Système de surveillance selon la revendication 1, **caractérisé en ce que** le conducteur indicateur (22) est disposé comme une antenne en boucle, que le générateur alimente le signal d'excitation dans le conducteur indicateur (22) et que le circuit (24) détecte un paramètre électrique sensible par rapport à la géométrie de l'antenne en tant que variable.

6. Système de surveillance selon la revendication 1, **caractérisé en ce que** le conducteur indicateur (22) est disposé comme une antenne dipôle, que le générateur alimente le signal d'excitation dans le conducteur indicateur (12) et que le circuit (14) détecte un paramètre électrique sensible par rapport à la géométrie de l'antenne en tant que variable.

7. Système de surveillance selon l'une quelconque des revendications 1 à 6, **caractérisé en ce que** le dispositif de surveillance comprend une unité d'évaluation connectée au circuit.

8. Système de surveillance selon la revendication 7, **caractérisé en ce que** l'unité d'évaluation (6) présente une mémoire pour des données d'application et comprend une logique qui évalue le signal émis par le circuit (14; 24; 44; 54; 64) en fonction des données d'application mémorisées.

9. Système de surveillance selon l'une quelconque des revendications 7 à 8, **caractérisé en ce que** l'unité d'évaluation (6) comprend une interface de communication pour la connexion à un système de niveau supérieur (7).

10. Système de surveillance selon l'une quelconque des revendications 1 à 9, **caractérisé en ce que** le dispositif de surveillance comprend un capteur de température (63) pour la normalisation de la température.

11. Système de surveillance selon l'une quelconque des revendications 1 à 10, **caractérisé en ce qu'**il est prévu un circuit logique (25; 45; 65), en particulier un microcontrôleur, un ASIC, un DSP ou analogue, qui traite numériquement la grandeur électrique détectée, en particulier pour la comparer à une référence depuis une mémoire de valeurs de référence.

12. Système de surveillance selon l'une quelconque des revendications 7 à 11, **caractérisé en ce que** le circuit (14; 24 44 ; 54; 64) détecte la grandeur électrique de manière continue dans le temps ou discrète dans le temps pendant le fonctionnement continu de la chaîne de guidage d'énergie (1), et **en ce qu'**un filtre, en particulier un filtre de moyenne ou de crête, est prévu dans le circuit (14; 24 44 ; 54; 64) ou dans l'unité d'évaluation (6).

13. Système de surveillance selon l'une quelconque des revendications 1 à 12, **caractérisé en ce que** le dispositif de surveillance (10; 20; 40; 50; 60) est agencé sous la forme d'un module fixe sur la base (2) et le ou les conducteurs indicateurs (12; 22; 42; 52; 62) est ou sont reliés au circuit (14; 24 ; 44; 54; 64) d'un côté à l'extrémité de raccordement pour la base (2).

14. Utilisation d'un système de surveillance (10; 20; 40; 50) selon l'une quelconque des revendications 1 à 13 pour surveiller le parcours spatial de la chaîne de guidage d'énergie (1) en fonctionnement continu.
